# EUROPEAN PATENT APPLICATION

(11) **EP 4 142 101 A1**
(43) Date of publication of application: **01.03.2023**
(21) Application number: 22184680.1
(22) Date of filing: 13.07.2022
(51) Int. Cl.: H02J 7/00

(54) **STORAGE BATTERY CONTROL DEVICE, ENERGY STORAGE SYSTEM, AND STORAGE BATTERY CONTROL METHOD**

(30) Priority: 17.08.2021 JP 2021132537
(71) Applicant: Yazaki Corporation, Minato-ku Tokyo 108-8333 (JP)
(72) Inventor: Ono, Chihiro, Susono-shi, Shizuoka, 410-1194 (JP); Syouda, Takahiro, Susono-shi, Shizuoka, 410-1194 (JP)
(74) Representative: Grünecker Patent- und Rechtsanwälte PartG mbB

(57) **Abstract**

A storage battery control device for controlling an energy storage system including storage batteries connected in series, bypass units that bypass the storage batteries respectively, and a current sensor that detects a charge and discharge current flowing from or into the storage batteries. Each of the bypass units includes a bypass line that bypasses the storage battery, a bypass switch that connects and cuts off the bypass line, and a cutoff switch that connects and cuts off the storage battery. The storage battery control device is configured to detect a zero current state in a case that both the bypass switch and the cutoff switch are in a cutoff state in at least one of the bypass units, and perform offset correction of the current sensor based on an output of the current sensor when the zero current state is detected.

## Description

### TECHNICAL FIELD

The present disclosure relates to a storage battery control device, an energy storage system, and a storage battery control method.

### BACKGROUND ART

As a method of estimating a state of charge (SOC) of a storage battery, there is known a current integration method of estimating a state of charge based on an integrated current value obtained by integrating a charge and discharge current with time (for example, refer to WO2007/074614, WO99/61929, and JP-A-2000-150003).

In addition, as a system for controlling discharge of a battery device in which a plurality of batteries are connected in series, there is known a system that selects, based on a state of each battery, a battery avoiding discharging, and bypasses the battery avoiding discharging to discharge from another battery (for example, refer to JP-A-2013-31247). In the system described in JP-A-2013-31247 a cutoff switch for connecting and cutting off a battery and a bypass switch for connecting and cutting off a bypass line are provided.

When the estimation of the state of charge based on the current integration method is continued for a long time, it is necessary to prevent an estimation error of the state of charge due to accumulation of detection errors (offset errors) of a current sensor. Therefore, it is necessary to perform offset correction of the current sensor. This offset correction is processing of detecting an output value of the current sensor during a period of a zero current state in which a charge and discharge current does not flow, and correcting the subsequent output value of the current sensor using the output value as an offset correction amount.

Here, when the offset correction is performed in the battery device, in which the plurality of batteries are connected in series, without the bypass function, if the cutoff switch for connecting and cutting off the battery device is turned OFF, the current state of the battery device is the zero current state. In this case, it is possible to easily determine whether the current state is the zero (zero current state). However, in the system having the bypass function described in JP-A-2013-31247, when the offset correction is performed, even if the cutoff switch is turned OFF, if the bypass switch is turned ON, a charge and discharge current flows from another battery through the bypass line. In this case, it is difficult to easily determine whether the current state of the battery device is in the zero current state.

### SUMMARY OF INVENTION

In view of the above circumstances, an object of the present disclosure is to provide a storage battery control device, an energy storage system, and a storage battery control method, which are capable of performing offset correction of a current sensor by reliably detecting a zero current state in which a charge and discharge current of a storage battery does not flow, in the energy storage system including a plurality of storage batteries connected in series and a plurality of bypass units for bypassing the storage batteries respectively.

According to an aspect of the present disclosure, there is provided a storage battery control device for controlling an energy storage system including a plurality of storage batteries connected in series, a plurality of bypass units that bypass the storage batteries respectively, and a current sensor that detects a charge and discharge current flowing from or into the storage batteries, in which each of the plurality of bypass units includes a bypass line that bypasses the storage battery of a corresponding bypass unit among the plurality of bypass units, a bypass switch that connects and cuts off the bypass line, and a cutoff switch that connects and cuts off the storage battery of the corresponding bypass unit; and the storage battery control device is configured to detect, in a case that both the bypass switch and the cutoff switch are in a cutoff state in at least one of the plurality of bypass units, a zero current state in which the charge and discharge current does not flow from or into the storage batteries, and perform offset correction of the current sensor based on an output of the current sensor when the zero current state is detected.

According to an another aspect of the present disclosure, there is provided an energy storage system, including a plurality of storage batteries connected in series; a plurality of bypass units configured to bypass the storage batteries respectively; a current sensor configured to detect a charge and discharge current flowing from or into the storage batteries; and a storage battery control device configured to control the plurality of bypass units and perform offset correction of the current sensor, in which each of the plurality of bypass units includes: a bypass line configured to bypass the storage battery of a corresponding bypass unit among the plurality of bypass units; a bypass switch configured to connect and cut off the bypass line; and a cutoff switch configured to connect and cut off the storage battery of the corresponding bypass unit; and the storage battery control device is configured to detect, in a case that both the bypass switch and the cutoff switch are in a cutoff state in at least one of the plurality of bypass units, a zero current state in which the charge and discharge current does not flow from or into the storage batteries, and perform the offset correction of the current sensor based on an output of the current sensor when the zero current state is detected.

According to a further another aspect of the present disclosure, there is provided a storage battery control method for controlling an energy storage system using a computer, in which the energy storage system includes a plurality of storage batteries connected in series, a plurality of bypass units that bypass the storage batteries respectively, and a current sensor that detects a charge and discharge current flowing from or into the storage batteries, and each of the plurality of bypass units includes a bypass line that bypasses the storage battery of a corresponding bypass unit among the plurality of bypass units, a bypass switch that connects and cuts off the bypass line, and a cutoff switch that connects and cuts off the storage battery of the corresponding bypass unit, and the storage battery control method including: detecting, in a case that both the bypass switch and the cutoff switch are in a cutoff state in at least one of the plurality of bypass units, a zero current state in which the charge and discharge current does not flow from or into the storage batteries, and performing offset correction of the current sensor based on an output of the current sensor when the zero current state is detected.

According to the present disclosure, in an energy storage system including a plurality of storage batteries connected in series and a plurality of bypass units for bypassing the storage batteries respectively, offset correction of a current sensor can be performed by reliably detecting a zero current state in which a charge and discharge current of the storage battery does not flow in the energy storage system.

### BRIEF DESCRIPTION OF DRAWINGS

Fig. 1 is a diagram showing an outline of an energy storage system including a storage battery control device according to an embodiment of the present disclosure.
Fig. 2 is a diagram showing an outline of an energy storage system including a storage battery control device according to another embodiment of the present disclosure.
Fig. 3 is a diagram showing an outline of an energy storage system including a storage battery control device according to another embodiment of the present disclosure.
Fig. 4 is a diagram showing an outline of an energy storage system including a storage battery control device according to another embodiment of the present disclosure.

### DESCRIPTION OF EMBODIMENTS

Hereinafter, the present disclosure will be described according to a preferred embodiment. The present disclosure is not limited to the embodiments described below, and the embodiments described below can be appropriately modified without departing from the gist of the present disclosure. In addition, although some configurations are not illustrated or described in the embodiments to be described below, a known or well-known technique is appropriately applied to details of an omitted technique within a range in which no contradiction occurs to contents to be described below.

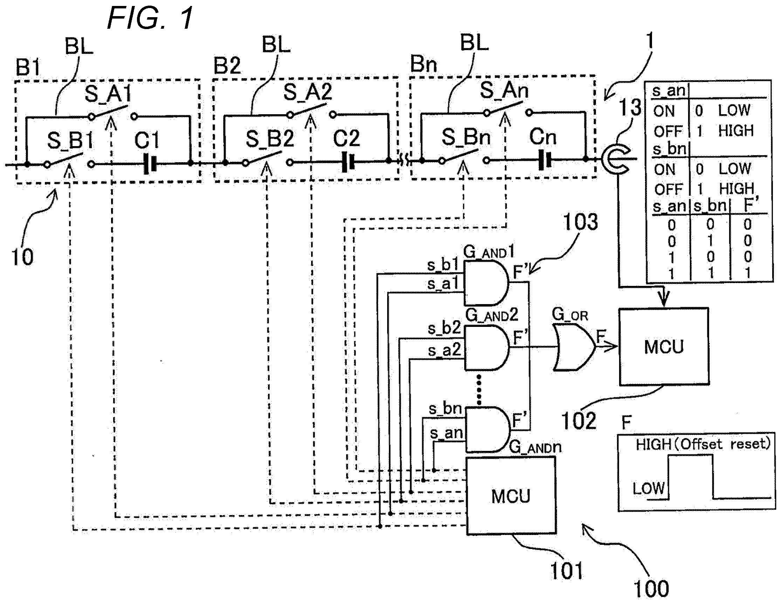

Fig. 1 is a diagram showing an outline of an energy storage system 1 including a storage battery control device 100 according to an embodiment of the present disclosure. As shown in this figure, the energy storage system 1 includes n (n is an integer of 2 or more) storage batteries C1 to Cn connected in series, n bypass circuits B1 to Bn, a current sensor 13, and a storage battery control device 100. The energy storage system 1 is an in-vehicle or stationary power supply.

The storage batteries C1 to Cn are storage battery cells, or storage battery modules or storage battery packs having a plurality of storage battery cells connected to one another. In addition, the storage batteries C1 to Cn are secondary batteries such as lithium ion batteries and lithium ion capacitors. Although not particularly limited, the storage batteries C1 to Cn of the present embodiment are obtained by recycling used batteries used in vehicles or the like, and degrees of deterioration of the storage batteries C1 to Cn are different from each other. When the storage batteries C1 to Cn are connected to form a storage battery system 10, a deterioration state of each of the storage batteries C1 to Cn is measured and the storage batteries C1 to Cn are selected according to a battery capacity of each of the storage batteries C1 to Cn, and then the storage batteries C1 to Cn are connected such that a total capacity of the energy storage system 1 satisfies the required capacity. It is not necessary to match the degrees of deterioration of the storage batteries C1 to Cn of the storage battery system 10 equal to each other, and it is sufficient that a total capacity of the storage battery system 10 satisfies the requirement of the energy storage system 1.

These storage batteries C1 to Cn are charged by being supplied with electric power from an external system (not shown) through a charge and discharge circuit (not shown), and discharge the charged electric power to supply the electric power to an external system. Here, the external system includes a load, a generator, or the like. When the energy storage system 1 is used in a vehicle, a driving motor, an air conditioner, various in-vehicle electrical components, or the like serve as loads. The driving motor serves as a load and also serves as a generator. In addition, when the energy storage system 1 is stationary, home appliances in a home, a commercial power supply system, a liquid crystal display, a communication module, or the like serve as loads, and a solar power generation system or the like serves as a power generator.

The bypass circuits B1 to Bn are provided corresponding to the storage batteries C1 to Cn, respectively. The bypass circuits B1 to Bn include bypass lines BL, bypass switches S_A1 to S_An, and cutoff switches S_B1 to S_Bn, respectively. The bypass line BL is an electric power line that bypasses each of the storage batteries C1 to Cn. The bypass switches S_A1 to S_An are provided on the bypass lines BL respectively. The bypass switches S_A1 to S_An are, for example, mechanical switches. Each of the cutoff switches S_B1 to S_Bn is provided between a positive electrode of each of the storage batteries C1 to Cn and one end of each of the bypass lines BL. The cutoff switches S_B1 to S_Bn are, for example, semiconductor switches.

The storage battery C1 at the starting end is connected to the external system such as a load via the charge and discharge circuit, and the storage battery Cn at the terminal end is also connected to the external system such as a load. When the bypass switches S_A1 to S_An are turned OFF and the cutoff switches S_B1 to S_Bn are turned ON in all the bypass circuits B1 to Bn of the storage battery system 10, all the storage batteries C1 to Cn of the storage battery system 10 are connected in series to the external system via the charge and discharge circuit. On the other hand, when the cutoff switches S_B1 to S_Bn are turned OFF and the bypass switches S_A1 to S_An are turned ON in any of the bypass circuits B1 to Bn of the storage battery system 10, any of the storage batteries C1 to Cn corresponding to the any of the bypass circuits B1 to Bn are bypassed.

The storage battery system 10 includes a current sensor 13. The current sensor 13 is provided at an end of the storage battery system 10, detects a charge and discharge current of the storage battery system 10, and outputs a detection result of the charge and discharge current to the storage battery control device 100.

The storage battery control device 100 includes a micro controller unit (MCU) 101, an MCU 102, and a logic circuit 103. The MCU 101 controls the bypass switches S_A1 to S_An and the cutoff switches S_B1 to S_Bn of the bypass circuits B1 to Bn. The MCU 102 measures a voltage of each of the storage batteries C1 to Cn based on an output of a voltage sensor (not shown), and measures the charge and discharge current of the storage battery system 10 based on the output of the current sensor 13.

The logic circuit 103 receives control signals s_a1 to s_an and s_b1 to s_bn of the MCU 101, and outputs a result of a logic operation (an output F) to the MCU 102. The logic circuit 103 includes AND gates G__{AND} 1 to G_{_AND} n of the same number as the bypass circuits B1 to Bn, and one OR gate G__{OR}. The control signals s_a1 to s_an of the bypass switches S_A1 to S_An and the control signals s_b1 to s_bn of the cutoff switches S_B1 to S_Bn are input to the AND gates G_{_AND} 1 to G_{_AND} n from the MCU 101, respectively.

The control signals s_a1 to s_an are "0" and "LOW" when the bypass switches S_A1 to S_An are turned ON (connected), and are "1" and "HIGH" when the bypass switches S_A1 to S_An are turned OFF (cut off). In addition, the control signals s_b1 to s_bn are "0" and "LOW" when the cutoff switches S_B1 to S_Bn are turned ON (connected), and are "1" and "HIGH" when the cutoff switches S_B1 to S_Bn are turned OFF (cut off).

Outputs F' of the AND gates G_{_AND} 1 to G_{_AND} n are input to the OR gate G__{OR}. The outputs F' of the AND gates G_{_AND} 1 to G_{_AND} n are "1" when the control signals s_a1 to s_an and the control signals s_b1 to s_bn are both "1" and "HIGH". On the other hand, the outputs F' of the AND gates G_{_AND} 1 to G_{_AND} n are "0" when the control signals s_a1 to s_an and the control signals s_b1 to s_bn are both "0" or one of them is "0".

The output F of the OR gate G_{_OR} is input to the MCU 102. The output F of the OR gate G_{_OR} is "HIGH" when at least one of the outputs F' of the n AND gates G_{_AND} 1 to G_{_AND} n is "1". On the other hand, the output F of the OR gate G__{OR} is "LOW" when all the outputs F' of the n AND gates G_{_AND} 1 to G_{_AND} n are "0".

When the output F of the OR gate G__{OR} is "HIGH", the MCU 102 detects the zero current state in which the charge and discharge current of the storage battery system 10 does not flow. Then, the MCU 102 performs offset correction of the current sensor 13 when the zero current state is detected. Specifically, if the zero current state is detected, the MCU 102 stores the output of the current sensor 13 as an offset correction amount, and subtracts the offset correction amount from the subsequent current measurement value. On the other hand, when the output F of the OR gate G_{_OR} is "LOW", if the zero current state is not detected, the MCU 102 does not perform the offset correction of the current sensor 13.

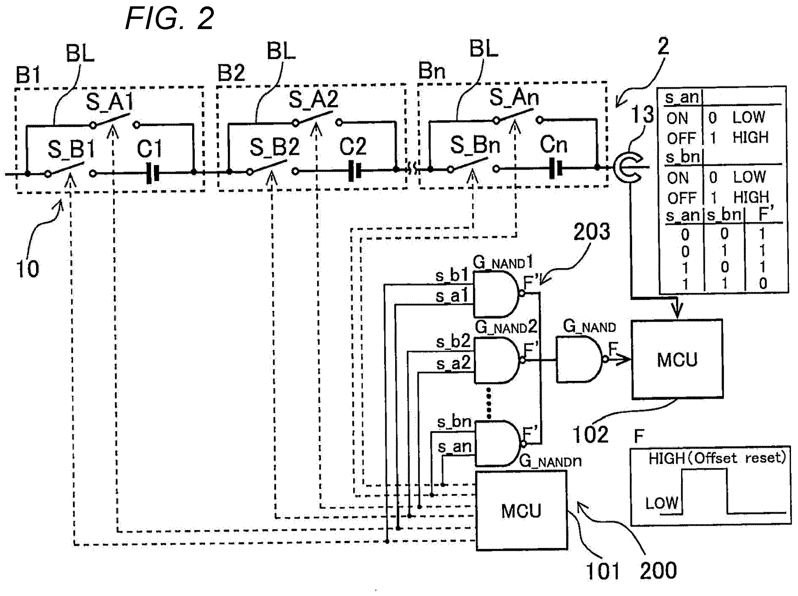

Fig. 2 is a diagram schematically showing an energy storage system 2 including a storage battery control device 200 according to another embodiment of the present disclosure. As shown in this figure, the storage battery control device 200 of the present embodiment includes a logic circuit 203 instead of the logic circuit 103 of the above embodiment.

The logic circuit 203 receives the control signals s_a1 to s_an and s_b1 to s_bn of the MCU 101, and outputs the result of the logic operation (the output F) to the MCU 102. The logic circuit 203 includes first NAND gates G__{NAND} 1 to G__{NAND} n of the same number as the bypass circuits B1 to Bn, and one second NAND gate G__{NAND}. The control signals s_a1 to s_an of the bypass switches S_A1 to S_An and the control signals s_b1 to s_bn of the cutoff switches S_B1 to S_Bn are input to the first NAND gates G__{NAND} 1 to G__{NAND} n from the MCU 101, respectively.

The control signals s_a1 to s_an are "0" and "LOW" when the bypass switches S_A1 to S_An are turned ON (connected), and are "1" and "HIGH" when the bypass switches S_A1 to S_An are turned OFF (cut off). In addition, the control signals s_b1 to s_bn are "0" and "LOW" when the cutoff switches S_B1 to S_Bn are turned ON (connected), and are "1" and "HIGH" when the cutoff switches S_B1 to S_Bn are turned OFF (cut off).

The outputs F' of the first NAND gates G_{_NAND} 1 to G_{_NAND} n are input to the second NAND gate G_{_NAND}. The outputs F' of the first NAND gates G_{_NAND} 1 to G_{_NAND} n are "0" when the control signals s_a1 to s_an and the control signals s_b1 to s_bn are both "1" and "HIGH". On the other hand, the outputs F' of the first NAND gates G_{_NAND} 1 to G_{_NAND} n are "1" when the control signals s_a1 to s_an and the control signals s_b1 to s_bn are both "0" or one of them is "0".

The output F of the second NAND gate G_{_NAND} is input to the MCU 102. The output F of the second NAND gate G_{_NAND} is "HIGH" when at least one of the outputs F' of the n first NAND gates G_{_NAND} 1 to G_{_NAND} n is "0". On the other hand, the output F of the second NAND gate G_{_NAND} is "LOW" when all the outputs F' of the n first NAND gates G_{_NAND} 1 to G_{_NAND} n are "1".

When the output F of the second NAND gate G_{_NAND} is "HIGH", the MCU 102 detects the zero current state in which the charge and discharge current of the storage battery system 10 does not flow. Then, the MCU 102 performs offset correction of the current sensor 13 when the zero current state is detected. Specifically, if the zero current state is detected, the MCU 102 stores the output of the current sensor 13 as an offset correction amount, and subtracts the offset correction amount from the subsequent current measurement value. On the other hand, when the output F of the second NAND gate G_{_NAND} is "LOW", if the zero current state is not detected, the MCU 102 does not perform the offset correction of the current sensor 13.

As described above, when the bypass switches S_A1 to S_An and the cutoff switches S_B1 to S_Bn are both in the cutoff state in at least one of a plurality of bypass circuits B1 to Bn, the storage battery control devices 100, 200 according to the above embodiments detect the zero current state in which the charge and discharge current of the energy storage system 1 does not flow. Then, the storage battery control devices 100, 200 perform the offset correction of the current sensor 13 according to the output of the current sensor 13 during detection of the zero current state. Accordingly, the zero current state of the energy storage systems 1, 2 including the bypass circuits B1 to Bn can be reliably detected, and the offset correction of the current sensor 13 can be performed.

Here, it is also possible to adopt a configuration in which it is determined whether the MCU 101 is in the zero current state, and the determination result is transmitted to the MCU 102. However, in this case, there is a possibility that a delay occurs due to the determination of the zero current state in the MCU 101, a waiting time of communication, or the like, and the MCU 102 that measures the current cannot accurately detect a timing at which the current state is the zero current state.

On the other hand, in the storage battery control devices 100, 200 of the present embodiment, the logic circuits 103, 203 perform logical operations using, as input signals, the control signals s_a1 to s_an and s_b1 to s_bn of the MCU 101 controlling the bypass switches S_A1 to S_An and the cutoff switches S_B1 to S_Bn. Then, the MCU 102 determines whether both the bypass switches S_A1 to S_An and the cutoff switches S_B1 to S_Bn are in the cutoff state in at least one of the plurality of bypass circuits B1 to Bn based on the outputs F of the logic circuits 103, 203. Accordingly, the MCU 102 can determine the timing at which the current state is the zero current state without determining the zero current state in the MCU 101 or communicating with the MCU 101. Therefore, it is possible to reliably detect the zero current state and perform offset processing of the current sensor 13.

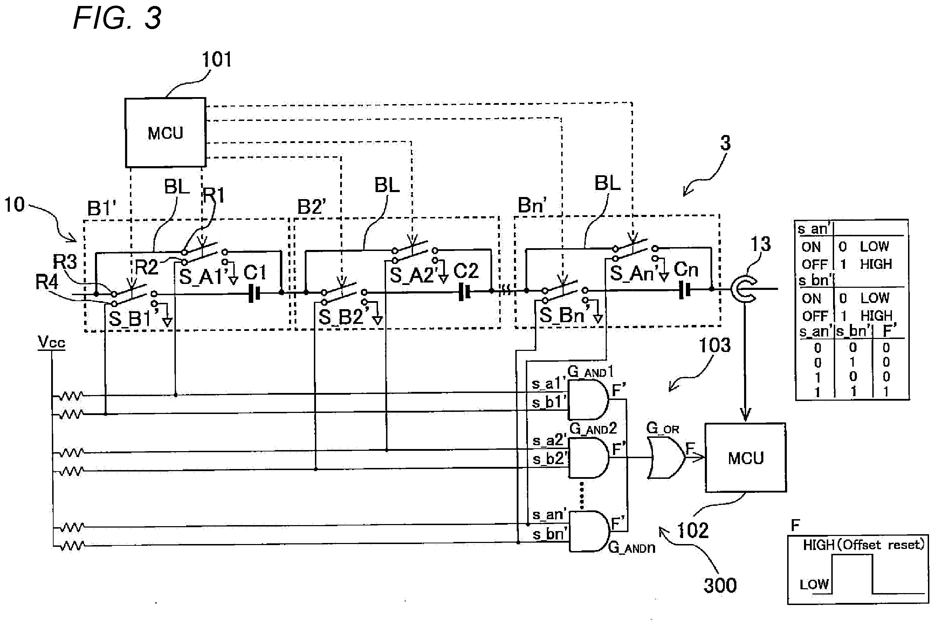

Fig. 3 is a diagram schematically showing an energy storage system 3 including a storage battery control device 300 according to another embodiment of the present disclosure. As shown in this figure, the energy storage system 3 of the present embodiment includes bypass circuits B1' to Bn' instead of the bypass circuits B1 to Bn of the above embodiment. The bypass circuits B1' to Bn' include bypass switches S_A1' to S_An' instead of the bypass switches S_A1 to S_An of the above embodiment, and include cutoff switches S_B1' to S_Bn' instead of the cutoff switches S_B1 to S_Bn of the above embodiment.

The bypass switches S_A1' to S_An' are 2a-contact relays. When one a-contact R1 is turned ON/OFF by the control signal of the MCU 101, the other a-contact R2 is turned ON/OFF. Signals s_a1' to s_an' corresponding to ON/OFF of the other a-contact R2 ("0" and "LOW" in the case of ON, and "1" and "HIGH" in the case of OFF) are input to AND gates G_{_AND} 1 to G_{_AND} n of the logic circuit 103.

The cutoff switches S_B1' to S_Bn' are 2a-contact relays. When one a-contact R3 is turned ON/OFF by the control signal of the MCU 101, the other a-contact R4 is turned ON/OFF. Signals s_b1' to s_bn' corresponding to ON/OFF of the other a-contact R4 ("0" and "LOW" in the case of ON and "1" and "HIGH" in the case of OFF) are input to the AND gates G_{_AND} 1 to G_{_AND} n of the logic circuit 103.

The outputs F' of the AND gates G_{_AND} 1 to G_{_AND} n are input to the OR gate G_{_OR}. The outputs F' of the AND gates G_{_AND} 1 to G_{_AND} n are "1" when the input signals s_a1' to s_an' from the bypass switches S_A1' to S_An' and the input signals s_b1' to s_bn' from the cutoff switches S_B1' to S_Bn' are both "1" and "HIGH". On the other hand, the outputs F' of the AND gates G_{_AND} 1 to G_{_AND} n are "0" when the input signals s_a1' to s_an' from the bypass switches S_A1' to S_An' and the input signals s_b1' to s_bn' from the cutoff switches S_B1' to S_Bn' are both "0" and one of them is "0".

The output F of the OR gate G_{_OR} is input to the MCU 102. The output F of the OR gate G_{_OR} is "HIGH" when at least one of the outputs F' of the n AND gates G_{_AND} 1 to G_{_AND} n is "1". On the other hand, the output F of the OR gate G_{_OR} is "LOW" when all the outputs F' of the n AND gates G_{_AND} 1 to G_{_AND} n are "0".

When the output F of the OR gate G_{_OR} is "HIGH", the MCU 102 detects the zero current state in which the charge and discharge current of the storage battery system 10 does not flow. Then, the MCU 102 performs offset correction of the current sensor 13 when the zero current state is detected. Specifically, if the zero current state is detected, the MCU 102 stores the output of the current sensor 13 as an offset correction amount, and subtracts the offset correction amount from the subsequent current measurement value. On the other hand, when the output F of the OR gate G_{_OR} is "LOW", if the zero current state is not detected, the MCU 102 does not perform the offset correction of the current sensor 13.

Here, when the control signals s_a1 to s_an and s_b1 to s_bn of the MCU 101 are ON or OFF, the storage battery control devices 100, 200 of the above embodiments regard the bypass switches S_A1 to S_An and the cutoff switches S_B1 to S_Bn as ON or OFF. On the other hand, the storage battery control device 300 of the present embodiment detects actual ON/OFF of the bypass switches S_A1 to S_An and the cutoff switches S_B1 to S_Bn at the other a-contacts R2, R4. Accordingly, the detection of the zero current state can be performed according to the actual ON/OFF states of the bypass switches S_A1 to S_An and the cutoff switches S_B1 to S_Bn.

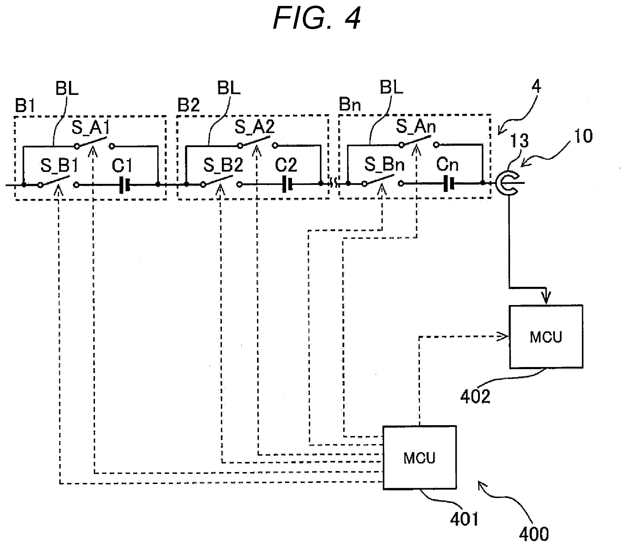

Fig. 4 is a diagram schematically showing an energy storage system 4 including a storage battery control device 400 according to another embodiment of the present disclosure. As shown in this figure, the storage battery control device 400 of the present embodiment includes an MCU 401 instead of the MCU 101 of the above embodiment, and an MCU 402 instead of the MCU 102 of the above embodiment.

When the MCU 401 executes bypass processing of any one of the storage batteries C1 to Cn, the MCU 401 switches from a connection state, in which the bypass switches S_A1 to S_An are OFF and the cutoff switches S_B1 to S_Bn are ON, to a bypass state, in which the bypass switches S_A1 to S_An are ON and the cutoff switches S_B1 to S_Bn are OFF, via the state in which both the switches are OFF. Such bypass processing is executed from the viewpoint of preventing a short circuit.

The MCU 401 transmits a signal notifying the execution of the bypass processing to the MCU 402 before executing the bypass processing of any of the storage batteries C1 to Cn. A transmission timing of the signal is a predetermined time before the timing at which both the switches are in OFF states during the execution of the bypass processing. The MCU 402 determines that the current state is the zero current state after the predetermined time after receiving the signal notifying the execution of the bypass processing from the MCU 401, and executes the offset correction of the current sensor 13. That is, in the storage battery control device 400 of the present embodiment, the MCU 401 notifies the MCU 402 in advance of the timing at which the zero current state is inevitably formed from the viewpoint of preventing the short circuit. The MCU 402 executes the offset correction of the current sensor 13 according to the timing.

Although the present disclosure has been described based on the embodiments, the present disclosure is not limited to the embodiments described above. The present disclosure may be modified as appropriate without departing from the gist of the present disclosure, or known and well-known techniques may be combined as appropriate.

For example, in the above embodiments, the energy storage systems 1 to 4 including one storage battery system 10 are described as an example, but the present disclosure can also be applied to an energy storage system including two or more storage battery systems 10.

Here, characteristics of the embodiment of the storage battery control device, the energy storage system, and the storage battery control method according to the present disclosure described above are summarized briefly in the following [1] to [5].
[1] A storage battery control device (100, 200, 300, 400) for controlling an energy storage system (1, 2, 3, 4) including a plurality of storage batteries (C1 to Cn) connected in series, a plurality of bypass units (B1 to Bn, B1' to Bn') that bypass the storage batteries (C1 to Cn) respectively, and a current sensor (13) that detects a charge and discharge current flowing from or into the storage batteries (C1 to Cn), in which
   each of the plurality of bypass units (B1 to Bn, B1' to Bn') includes a bypass line (BL) that bypasses the storage battery (C1 to Cn) of a corresponding bypass unit (B1 to Bn, B1' to Bn') among the plurality of bypass units (B1 to Bn, B1' to Bn'), a bypass switch (S_A1 to S_An, S_A1' to S_An') that connects and cuts off the bypass line (BL), and a cutoff switch (S_B1 to S_Bn, S_B1' to S_Bn') that connects and cuts off the storage battery (C1 to Cn) of the corresponding bypass unit (B1 to Bn, B1' to Bn'); and
   the storage battery control device (100, 200, 300, 400) is configured to
      detect, in a case that both the bypass switch (S_A1 to S_An, S_A1' to S_An') and the cutoff switch (S_B1 to S_Bn, S_B1' to S_Bn') are in a cutoff state in at least one of the plurality of bypass units (B1 to Bn, B1' to Bn'), a zero current state in which the charge and discharge current does not flow from or into the storage batteries (C1 to Cn); and
      perform offset correction of the current sensor (13) based on an output of the current sensor (13) when the zero current state is detected.
[2] The storage battery control device (100, 200, 300, 400) according to above [1], further including:
   a first control unit (101, 401) configured to control the bypass switch (S_A1 to S_An, S_A1' to S_An') and the cutoff switch (S_B1 to S_Bn, S_B1' to S_Bn') of each of the plurality of bypass units (B1 to Bn, B1' to Bn');
   a second control unit (102, 402) configured to measure the charge and discharge current flowing from or into the storage batteries (C1 to Cn) based on the output of the current sensor (13); and
   a logic circuit (103) configured to receive a control signal of the first control unit (101, 401) as an input signal, in which
   the second control unit (102, 402) is configured to determine whether both the bypass switch (S_A1 to S_An, S_A1' to S_An') and the cutoff switch (S_B1 to S_Bn, S_B1' to S_Bn') of at least one of the plurality of bypass units (B1 to Bn, B1' to Bn') are in the cutoff state based on an output of the logic circuit (103).
[3] The storage battery control device (300) according to above [1], further including:
   a first control unit (101) configured to control the bypass switch (S_A1' to S_An') and the cutoff switch (S_B1' to S_Bn') of each of the plurality of bypass units (B1' to Bn');
   a second control unit (102) configured to measure the charge and discharge current flowing from or into the storage batteries (C1 to Cn) based on the an output of the current sensor (13);
   a first state detection unit (R2) configured to detect a state of the bypass switch (S_A1' to S_An') of each of the plurality of bypass units (B1' to Bn');
   a second state detection unit (R4) configured to detect a state of the cutoff switch (S_B1' to S_Bn') of each of the plurality of bypass units (B1' to Bn'); and
   a logic circuit (103) configured to receive detection signals of the first state detection unit (R2) and the second state detection unit (R4) as input signals, in which
   the second control unit (102) is configured to determine whether both the bypass switch (S_A1' to S_An') and the cutoff switch (S_B1' to S_Bn') of at least one of the plurality of bypass units (B1' to Bn') are in the cutoff state based on an output of the logic circuit (103).
[4] An energy storage system (1, 2, 3, 4), including:
   a plurality of storage batteries (C1 to Cn) connected in series;
   a plurality of bypass units (B1 to Bn, B1' to Bn') configured to bypass the storage batteries (C1 to Cn) respectively;
   a current sensor (13) configured to detect a charge and discharge current flowing from or into the storage batteries (C1 to Cn); and
   a storage battery control device (100, 200, 300, 400) configured to control the plurality of bypass units (B1 to Bn, B1' to Bn') and perform offset correction of the current sensor (13), in which
   each of the plurality of bypass units (B1 to Bn, B1' to Bn') includes:
      a bypass line (BL) configured to bypass the storage battery (C1 to Cn) of a corresponding bypass unit (B1 to Bn, B1' to Bn') among the plurality of bypass units (B1 to Bn, B1' to Bn');
      a bypass switch (S_A1 to S_An, S_A1' to S_An') configured to connect and cut off the bypass line (BL); and
      a cutoff switch (S_B1 to S_Bn, S_B1' to S_Bn') configured to connect and cut off the storage battery (C1 to Cn) of the corresponding bypass unit (B1 to Bn, B1' to Bn'); and
   the storage battery control device (100, 200, 300, 400) is configured to
      detect, in a case that both the bypass switch (S_A1 to S_An, S_A1' to S_An') and the cutoff switch (S_B1 to S_Bn, S_B1' to S_Bn') are in a cutoff state in at least one of the plurality of bypass units (B1 to Bn, B 1' to Bn'), a zero current state in which the charge and discharge current does not flow from or into the storage batteries (C1 to Cn); and
      perform the offset correction of the current sensor (13) based on an output of the current sensor (13) when the zero current state is detected.
[5] A storage battery control method for controlling an energy storage system (1, 2, 3, 4) using a computer, in which
   the energy storage system (1, 2, 3, 4) includes a plurality of storage batteries (C1 to Cn) connected in series, a plurality of bypass units (B1 to Bn, B1' to Bn') that bypass the storage batteries (C1 to Cn) respectively, and a current sensor (13) that detects a charge and discharge current flowing from or into the storage batteries (C1 to Cn), and each of the plurality of bypass units (B1 to Bn, B1' to Bn') includes a bypass line (BL) that bypasses the storage battery (C1 to Cn)of a corresponding bypass unit (B1 to Bn, B1' to Bn') among the plurality of bypass units (B1 to Bn, B1' to Bn'), a bypass switch (S_A1 to S_An, S_A1' to S_An') that connects and cuts off the bypass line (BL), and a cutoff switch (S_B1 to S_Bn, S_B1' to S_Bn') that connects and cuts off the storage battery (C1 to Cn) of the corresponding bypass unit (B1 to Bn, B1' to Bn'), and
   the storage battery control method including:
      detecting, in a case that both the bypass switch (S_A1 to S_An, S_A1' to S_An') and the cutoff switch (S_B1 to S_Bn, S_B1' to S_Bn') are in a cutoff state in at least one of the plurality of bypass units (B1 to Bn, B1' to Bn'), a zero current state in which the charge and discharge current does not flow from or into the storage batteries (C1 to Cn); and
      performing offset correction of the current sensor (13) based on an output of the current sensor (13) when the zero current state is detected.

## Claims

1. A storage battery control device (100, 200, 300, 400) for controlling an energy storage system (1, 2, 3, 4) including a plurality of storage batteries (C1 to Cn) connected in series, a plurality of bypass units (B1 to Bn, B1' to Bn') that bypass the storage batteries (C1 to Cn) respectively, and a current sensor (13) that detects a charge and discharge current flowing from or into the storage batteries (C1 to Cn), wherein
each of the plurality of bypass units (B1 to Bn, B1' to Bn') includes a bypass line (BL) that bypasses the storage battery (C1 to Cn) of a corresponding bypass unit (B1 to Bn, B1' to Bn') among the plurality of bypass units (B1 to Bn, B1' to Bn'), a bypass switch (S_A1 to S_An, S_A1' to S_An') that connects and cuts off the bypass line (BL), and a cutoff switch (S_B1 to S_Bn, S_B1' to S_Bn') that connects and cuts off the storage battery (C1 to Cn) of the corresponding bypass unit (B1 to Bn, B1' to Bn'); and
the storage battery control device (100, 200, 300, 400) is configured to
detect, in a case that both the bypass switch (S_A1 to S_An, S_A1' to S_An') and the cutoff switch (S_B1 to S_Bn, S_B1' to S_Bn') are in a cutoff state in at least one of the plurality of bypass units (B1 to Bn, B1' to Bn'), a zero current state in which the charge and discharge current does not flow from or into the storage batteries (C1 to Cn); and
perform offset correction of the current sensor (13) based on an output of the current sensor (13) when the zero current state is detected.

2. The storage battery control device (100, 200, 300, 400) according to claim 1, further comprising:
a first control unit (101, 401) configured to control the bypass switch (S_A1 to S_An, S_A1' to S_An') and the cutoff switch (S_B1 to S_Bn, S_B1' to S_Bn') of each of the plurality of bypass units (B1 to Bn, B1' to Bn');
a second control unit (102, 402) configured to measure the charge and discharge current flowing from or into the storage batteries (C1 to Cn) based on the output of the current sensor (13); and
a logic circuit (103) configured to receive a control signal of the first control unit (101, 401) as an input signal, wherein
the second control unit (102) is configured to determine whether both the bypass switch (S_A1 to S_An, S_A1' to S_An') and the cutoff switch (S_B1 to S_Bn, S_B1' to S_Bn') of at least one of the plurality of bypass units (B1 to Bn, B1' to Bn') are in the cutoff state based on an output of the logic circuit (103).

3. The storage battery control device (300) according to claim 1, further comprising:
a first control unit (101) configured to control the bypass switch (S_A1' to S_An') and the cutoff switch (S_B1' to S_Bn') of each of the plurality of bypass units (B1' to Bn');
a second control unit (102) configured to measure the charge and discharge current flowing from or into the storage batteries (C1 to Cn) based on the an output of the current sensor (13);
a first state detection unit (R2) configured to detect a state of the bypass switch (S_A1' to S_An') of each of the plurality of bypass units (B1' to Bn');
a second state detection unit (R4) configured to detect a state of the cutoff switch (S_B1' to S_Bn') of each of the plurality of bypass units (B1' to Bn'); and
a logic circuit (103) configured to receive detection signals of the first state detection unit (R2) and the second state detection unit (R4) as input signals, wherein
the second control unit (102, 402) is configured to determine whether both the bypass switch (S_A1' to S_An') and the cutoff switch (S_B1' to S_Bn') of at least one of the plurality of bypass units (B1' to Bn') are in the cutoff state based on an output of the logic circuit (103).

4. An energy storage system (1, 2, 3, 4), comprising:
a plurality of storage batteries (C1 to Cn) connected in series;
a plurality of bypass units (B1 to Bn, B1' to Bn') configured to bypass the storage batteries (C1 to Cn) respectively;
a current sensor (13) configured to detect a charge and discharge current flowing from or into the storage batteries (C1 to Cn); and
a storage battery control device (100, 200, 300, 400) configured to control the plurality of bypass units (B1 to Bn, B1' to Bn') and perform offset correction of the current sensor (13), wherein
each of the plurality of bypass units (B1 to Bn, B1' to Bn') comprises:
a bypass line (BL) configured to bypass the storage battery (C1 to Cn) of a corresponding bypass unit (B1 to Bn, B1' to Bn') among the plurality of bypass units (B1 to Bn, B1' to Bn');
a bypass switch (S_A1 to S_An, S_A1' to S_An') configured to connect and cut off the bypass line (BL); and
a cutoff switch (S_B1 to S_Bn, S_B1' to S_Bn') configured to connect and cut off the storage battery (C1 to Cn) of the corresponding bypass unit (B1 to Bn, B1' to Bn'); and
the storage battery control device (100, 200, 300, 400) is configured to
detect, in a case that both the bypass switch (S_A1 to S_An, S_A1' to S_An') and the cutoff switch (S_B1 to S_Bn, S_B1' to S_Bn') are in a cutoff state in at least one of the plurality of bypass units (B1 to Bn, B1' to Bn'), a zero current state in which the charge and discharge current does not flow from or into the storage batteries (C1 to Cn); and
perform the offset correction of the current sensor (13) based on an output of the current sensor (13) when the zero current state is detected.

5. A storage battery control method for controlling an energy storage system (1, 2, 3, 4) using a computer, wherein
the energy storage system (1, 2, 3, 4) includes a plurality of storage batteries (C1 to Cn) connected in series, a plurality of bypass units (B1 to Bn, B1' to Bn') that bypass the storage batteries (C1 to Cn) respectively, and a current sensor (13) that detects a charge and discharge current flowing from or into the storage batteries (C1 to Cn), and each of the plurality of bypass units (B1 to Bn, B1' to Bn') includes a bypass line (BL) that bypasses the storage battery (C1 to Cn)of a corresponding bypass unit (B1 to Bn, B1' to Bn') among the plurality of bypass units (B1 to Bn, B1' to Bn'), a bypass switch (S_A1 to S_An, S_A1' to S_An') that connects and cuts off the bypass line (BL), and a cutoff switch (S_B1 to S_Bn, S_B1' to S_Bn') that connects and cuts off the storage battery (C1 to Cn) of the corresponding bypass unit (B1 to Bn, B1' to Bn'); and
the storage battery control method comprising:
detecting, in a case that both the bypass switch (S_A1 to S_An, S_A1' to S_An') and the cutoff switch (S_B1 to S_Bn, S_B1' to S_Bn') are in a cutoff state in at least one of the plurality of bypass units (B1 to Bn, B1' to Bn'), a zero current state in which the charge and discharge current does not flow from or into the storage batteries (C1 to Cn); and
performing offset correction of the current sensor (13) based on an output of the current sensor (13) when the zero current state is detected.
